# EUROPEAN PATENT APPLICATION

(11) **EP 4 718 694 A1**
(43) Date of publication of application: **01.04.2026**
(21) Application number: 25201749.6
(22) Date of filing: 11.09.2025
(51) Int. Cl.: H02M 1/00, H02M 1/08, G05F 1/613, H02M 1/15, G05F 3/18, H02M 3/04

(54) **VOLTAGE SUPPLY FOR SWITCH CONTROLLER IN CONVERTER**

(30) Priority: 26.09.2024 CN 202411354931
(71) Applicant: Huawei Digital Power Technologies Co., Ltd., Shenzhen, Guangdong 518043 (CN)
(72) Inventor: LI, Lei, Shenzhen, 518043 (CN); HU, Tianqi, Shenzhen, 518043 (CN); YE, Yong, Shenzhen, 518043 (CN); CHANG, Guozhu, Shenzhen, 518043 (CN); HAN, Lang, Shenzhen, 518043 (CN)
(74) Representative: Gill Jennings & Every LLP

(57) **Abstract**

This application provides a power converter. In a drive circuit, a drive power supply is connected in parallel to a voltage regulator circuit. The voltage regulator circuit includes a first switching transistor and a first voltage regulator diode that are connected in series between a power supply voltage output end and a reference voltage output end. An on/off state of the first switching transistor is controlled, so that a state of the first voltage regulator diode being connected to or disconnected from the drive power supply may be switched, thereby implementing voltage stabilization and change control of a power supply voltage provided by the drive power supply. A control circuit generates, based on the power supply voltage, a turn-on/turn-off voltage of a drive signal sent to a switching transistor in a power conversion circuit. Therefore, the power supply voltage can be changed to change the turn-on/turn-off voltage of the drive signal, thereby changing a switching speed of the switching transistor in the power conversion circuit. When the turn-on/turn-off voltage of the drive signal is reduced, a peak voltage of the switching transistor may be reduced. When the turn-on/turn-off voltage of the drive signal is increased, the switching speed of the switching transistor may be increased and a loss may be reduced.

## Description

### TECHNICAL FIELD

The present invention relates to the field of power electronics technologies, and in particular, to a power converter.

### BACKGROUND

Currently, switching devices used by high-power converters in the power electronics industry, for example, switching transistors such as an insulated gate bipolar transistor (insulated gate bipolar transistor, IGBT) and a metal-oxide-semiconductor field-effect transistor (metal-oxide-semiconductor field-effect transistor, MOSFET), all require an external voltage to drive the switching device to be turned on. A value of a drive voltage directly determines a switching speed of the switching transistor, and the switching speed of the switching transistor directly affects key characteristics such as a switching loss and a switching stress. To reduce the switching loss of the switching transistor and improve overall efficiency of a power converter, a higher drive voltage is usually selected to accelerate switchover between turn-on and turn-off of the switching transistor. In some application scenarios, for example, for a photovoltaic inverter, due to a wide input voltage range, in a working condition of a high input voltage, a faster switching speed causes a larger voltage peak stress; or in a working condition of a low input voltage, a slower switching speed causes a larger switching loss, which directly leads to reduced efficiency. Therefore, how to resolve this problem becomes a key to improving product competitiveness and ensuring product reliability.

### SUMMARY

This application provides a power converter, to resolve voltage peak and loss problems of a switching transistor in the power converter in a working condition of a wide input voltage range.

According to a first aspect, this application provides a power converter, including a power conversion circuit and a drive circuit. The power conversion circuit includes at least one switching transistor, the drive circuit is configured to send a drive signal to the switching transistor in the power conversion circuit, and the drive signal is used to control an on/off state of the switching transistor. The drive circuit specifically includes a drive power supply and a voltage regulator circuit. The drive power supply includes a power supply voltage output end and a reference voltage output end. The drive power supply is configured to provide a power supply voltage between the power supply voltage output end and the reference voltage output end. Specifically, the power supply voltage may be provided to a control circuit. The control circuit generates a turn-on/turn-off voltage of the drive signal based on the power supply voltage. The control circuit sends the drive signal to a control end of the switching transistor, to control the on/off state of the switching transistor. The voltage regulator circuit includes a first switching transistor and a first voltage regulator diode, and the first switching transistor and the first voltage regulator diode are connected in series between the power supply voltage output end and the reference voltage output end. The voltage regulator circuit is configured to: change a voltage value of the power supply voltage and stabilize the voltage value of the power supply voltage. Specifically, when the first switching transistor is turned off, the voltage regulator circuit is in a disconnected state, that is, the first voltage regulator diode is floating-disposed, so that the output power supply voltage between the power supply voltage output end and the reference voltage output end is kept at a rated fixed value or within a defined range. When the first switching transistor is turned on, the voltage regulator circuit is in a connected state, that is, the first voltage regulator diode and the drive power supply form a parallel connection relationship, so that the output power supply voltage between the power supply voltage output end and the reference voltage output end is changed to a fixed voltage regulator value of the first voltage regulator diode, to change the output power supply voltage and stabilize the power supply voltage to the fixed value. This drives a change of the turn-on/turn-off voltage of the drive signal based on the change of the power supply voltage, to change a switching speed of the switching transistor in the power conversion circuit. Specifically, in a working condition of a high input voltage, the power supply voltage is changed to reduce the turn-on/turn-off voltage of the drive signal, so that a peak voltage of the switching transistor may be reduced; or in a working condition of a low input voltage, the power supply voltage is changed to increase the turn-on/turn-off voltage of the drive signal, so that a switching speed of the switching transistor may be increased and a loss may be reduced.

In some embodiments of this application, to stabilize the power supply voltage to a fixed value when the voltage regulator circuit is in a disconnected state, the drive power supply may further include a second voltage regulator diode and a voltage divider capacitor that are connected in parallel between the power supply voltage output end and the reference voltage output end, and a voltage regulator value of the second voltage regulator diode needs to be greater than the voltage regulator value of the first voltage regulator diode. When the first switching transistor is turned off, the voltage value of the power supply voltage is the voltage regulator value of the second voltage regulator diode. In this way, when the first switching transistor is turned off, the voltage regulator circuit is in the disconnected state, that is, the first voltage regulator diode is floating-disposed, so that the second voltage regulator diode keeps the output power supply voltage between the power supply voltage output end and the reference voltage output end at a fixed voltage regulator value of the second voltage regulator diode. When the first switching transistor is turned on, the voltage regulator circuit is in the connected state, that is, the first voltage regulator diode and the drive power supply form the parallel connection relationship, so that the output power supply voltage between the power supply voltage output end and the reference voltage output end is changed to the fixed voltage regulator value of the first voltage regulator diode. The on/off state of the first switching transistor is changed, to change the output power supply voltage and stabilize the output power supply voltage. This drives the change of the turn-on/turn-off voltage of the drive signal based on the change of the power supply voltage, to change the switching speed of the switching transistor in the power conversion circuit.

In this application, a type of the power supply voltage that needs to be stabilized and controlled may be determined based on a type of the switching transistor used in the power conversion circuit. For example, when the switching transistor is an IGBT, a turn-on voltage of the drive signal is a positive voltage, and a turn-off voltage of the drive signal is a negative voltage. The drive power supply needs to provide a positive power supply voltage between a positive voltage output end and the reference voltage output end, and the control circuit generates the turn-on voltage of the IGBT drive signal based on the positive power supply voltage. In addition, the drive power supply further needs to provide a negative power supply voltage between a negative voltage output end and the reference voltage output end, and the control circuit generates the turn-off voltage of the IGBT drive signal based on the negative power supply voltage. According to a requirement, change of the positive power supply voltage may be independently controlled and the positive power supply voltage may be stabilized, or change of the negative power supply voltage may be independently controlled and the negative power supply voltage may be stabilized, or both the positive power supply voltage and the negative power supply voltage may be controlled. For another example, when the switching transistor is an N-type MOSFET, a turn-on voltage of an NMOS drive signal is a positive voltage, and a turn-off voltage of the NMOS drive signal is a reference voltage. The drive power supply needs to provide only a positive power supply voltage between a positive voltage output end and the reference voltage output end, and the control circuit generates the turn-on voltage of the NMOS drive signal based on the positive power supply voltage. According to a requirement, change of the positive power supply voltage may be independently controlled and the positive power supply voltage may be stabilized. When the switching transistor is a P-type MOSFET, a turn-on voltage of a PMOS drive signal is a negative voltage, and a turn-off voltage of the PMOS drive signal is a reference voltage. The drive power supply needs to provide only a negative power supply voltage between a negative voltage output end and the reference voltage output end, and the control circuit generates the turn-on voltage of the PMOS drive signal based on the negative power supply voltage. According to a requirement, change of the negative power supply voltage may be independently controlled and the negative power supply voltage may be stabilized.

In some embodiments of this application, the power supply voltage output end specifically includes the positive voltage output end, the drive power supply is configured to provide the positive power supply voltage between the positive voltage output end and the reference voltage output end, and the control circuit generates the turn-on voltage of the drive signal based on the positive power supply voltage. The voltage regulator circuit may specifically perform voltage change and stabilization on the positive power supply voltage, to change the turn-on voltage of the drive signal. Specifically, the first switching transistor and the first voltage regulator diode are connected in series between the positive voltage output end and the reference voltage output end, and the second voltage regulator diode and the voltage divider capacitor are connected in parallel between the positive voltage output end and the reference voltage output end. When the first switching transistor is turned off, the voltage regulator circuit is in the disconnected state, that is, the first voltage regulator diode is floating-disposed, so that the second voltage regulator diode keeps the positive power supply voltage at the fixed voltage regulator value of the second voltage regulator diode. When the first switching transistor is turned on, the voltage regulator circuit is in the connected state, that is, the first voltage regulator diode and the second voltage regulator diode form a parallel connection relationship, so that the positive power supply voltage is changed to the fixed voltage regulator value of the first voltage regulator diode. In this way, voltage change and stabilization of the positive power supply voltage are implemented, to change and stabilize the turn-on voltage of the drive signal. For example, when a turn-on peak voltage is high, the first voltage regulator diode is connected by turning on the first switching transistor, so that the positive power supply voltage can be reduced, thereby reducing the turn-on voltage of the drive signal, to reduce the turn-on peak voltage of the switching transistor. When a loss needs to be reduced, the first voltage regulator diode is floating-disposed by turning off the first switching transistor, so that the positive power supply voltage can be increased, thereby increasing the turn-on voltage of the drive signal, to increase a turn-on speed of the switching transistor and reduce the loss.

In the foregoing embodiments, if the power conversion circuit uses the IGBT as the switching transistor, the power supply voltage output end further needs to include the negative voltage output end, the drive power supply further needs to provide the negative power supply voltage between the negative voltage output end and the reference voltage output end, and the control circuit generates the turn-off voltage of the drive signal based on the negative power supply voltage. A voltage difference between the positive voltage output end and the negative voltage output end is a fixed value, and the negative power supply voltage changes as the positive power supply voltage changes. In this case, the drive power supply may further include a voltage divider resistor and a voltage divider capacitor that are connected in parallel between the negative voltage output end and the reference voltage output end. The negative power supply voltage decreases as the positive power supply voltage decreases. When the first voltage regulator diode is connected by turning on the first switching transistor, on the basis of reducing the positive power supply voltage and reducing the turn-on voltage of the drive signal to reduce the turn-on peak voltage of the switching transistor, the negative power supply voltage may be reduced and the turn-off voltage of the drive signal may be reduced to increase a turn-off speed of the switching transistor. When the first voltage regulator diode is floating-disposed by turning off the first switching transistor, on the basis of increasing the positive power supply voltage and increasing the turn-on voltage of the drive signal to increase the turn-on speed of the switching transistor and reduce the loss, the negative power supply voltage may be increased and the turn-off voltage of the drive signal may be increased to reduce a turn-off peak voltage of the switching transistor.

In some embodiments of this application, the power supply voltage output end specifically includes the negative voltage output end, the drive power supply is configured to provide the negative power supply voltage between the negative voltage output end and the reference voltage output end, and the control circuit generates the turn-off voltage of the drive signal based on the negative power supply voltage. The voltage regulator circuit may specifically perform voltage change and stabilization on the negative power supply voltage, to change the turn-off voltage of the drive signal. Specifically, the first switching transistor and the first voltage regulator diode are connected in series between the negative voltage output end and the reference voltage output end, and the second voltage regulator diode and the voltage divider capacitor are connected in parallel between the negative voltage output end and the reference voltage output end. When the first switching transistor is turned off, the voltage regulator circuit is in the disconnected state, that is, the first voltage regulator diode is floating-disposed, so that the second voltage regulator diode keeps the negative power supply voltage at the fixed voltage regulator value of the second voltage regulator diode. When the first switching transistor is turned on, the voltage regulator circuit is in the connected state, that is, the first voltage regulator diode and the second voltage regulator diode form a parallel connection relationship, so that the negative power supply voltage is changed to the fixed voltage regulator value of the first voltage regulator diode. In this way, voltage change and stabilization of the negative power supply voltage are implemented, to change and stabilize the turn-off voltage of the drive signal. For example, when a turn-off peak voltage is high, the first voltage regulator diode is connected by turning on the first switching transistor, so that an absolute value of the negative power supply voltage can be reduced, thereby reducing an absolute value of the turn-off voltage of the drive signal, to reduce the turn-off peak voltage of the switching transistor. When a loss needs to be reduced, the first voltage regulator diode is floating-disposed by turning off the first switching transistor, so that the absolute value of the negative power supply voltage can be increased, thereby increasing the absolute value of the turn-off voltage of the drive signal, to increase a turn-off speed of the switching transistor and reduce the loss.

In the foregoing embodiments, if the power conversion circuit uses the IGBT as the switching transistor, the power supply voltage output end further needs to include the positive voltage output end, the drive power supply further needs to provide the positive power supply voltage between the positive voltage output end and the reference voltage output end, and the control circuit generates the turn-on voltage of the drive signal based on the positive power supply voltage. A voltage difference between the positive voltage output end and the negative voltage output end is a fixed value, and the positive power supply voltage changes as the negative power supply voltage changes. In this case, the drive power supply may further include a voltage divider resistor and a voltage divider capacitor that are connected in parallel between the positive voltage output end and the reference voltage output end. The positive power supply voltage increases as the negative power supply voltage increases. When the first voltage regulator diode is connected by turning on the first switching transistor, on the basis of increasing the negative power supply voltage and increasing the turn-on voltage of the drive signal to reduce the turn-off peak voltage of the switching transistor, the positive power supply voltage may be increased and the turn-on voltage of the drive signal may be increased to increase a turn-on speed of the switching transistor. When the first voltage regulator diode is floating-disposed by turning off the first switching transistor, on the basis of reducing the negative power supply voltage and reducing the turn-off voltage of the drive signal to increase the turn-off speed of the switching transistor and reduce the loss, the positive power supply voltage may be reduced and the turn-on voltage of the drive signal may be reduced to reduce a turn-on peak voltage of the switching transistor.

In some embodiments of this application, the power supply voltage output end specifically includes a positive voltage output end and a negative voltage output end. The drive power supply is configured to: provide a positive power supply voltage between the positive voltage output end and the reference voltage output end, and provide a negative power supply voltage between the negative voltage output end and the reference voltage output end. The control circuit generates the turn-on voltage of the drive signal based on the positive power supply voltage, and the control circuit generates the turn-off voltage of the drive signal based on the negative power supply voltage. The voltage regulator circuit includes two groups including first switching transistors and first voltage regulator diodes. One group including a first switching transistor and a first voltage regulator diode is connected in series between the positive voltage output end and the reference voltage output end, and the other group including a first switching transistor and a first voltage regulator diode is connected in series between the negative voltage output end and the reference voltage output end. A voltage regulator value of the first voltage regulator diode may be set to any value according to a requirement, and the voltage regulator values of the two voltage regulator diodes may be the same or may be different. A voltage difference between the positive voltage output end and the negative voltage output end is a fixed value. When one first switching transistor is turned on and the other first switching transistor is turned off, the positive power supply voltage or the negative power supply voltage is controlled to be a fixed voltage regulator value of the first voltage regulator diode. In this way, voltage change and stabilization of the positive power supply voltage or the negative power supply voltage are implemented, to change and stabilize the turn-on voltage or the turn-off voltage of the drive signal. When the two first switching transistors are turned on at the same time, both the positive power supply voltage and the negative power supply voltage are controlled to be fixed values. In this way, voltage change and stabilization of the positive power supply voltage and the negative power supply voltage are implemented at the same time, to change and stabilize the turn-on/turn-off voltage of the drive signal.

In the foregoing embodiments, the drive power supply may further include two groups including voltage divider resistors and voltage divider capacitors. One group including a voltage divider resistor and a voltage divider capacitor is connected in parallel between the positive voltage output end and the reference voltage output end. In this way, when the positive power supply voltage is controllable and stable, the negative power supply voltage changes as the positive power supply voltage changes. The other group including a voltage divider resistor and a voltage divider capacitor is connected in parallel between the negative voltage output end and the reference voltage output end. In this way, when the negative power supply voltage is controllable and stable, the positive power supply voltage changes as the negative power supply voltage changes.

In some embodiments of this application, the voltage regulator circuit may usually further include a current-limiting resistor. The current-limiting resistor is connected in series between the first switching transistor and the first voltage regulator diode, to limit a current flowing through the first switching transistor, and protect the first switching transistor from overcurrent.

In some embodiments of this application, the voltage regulator circuit may usually further include a filter device, the filter device is connected to a control end of the first switching transistor, and the filter device includes at least one of a filter capacitor, a filter resistor, and a filter diode. Specifically, the control end of the first switching transistor is configured to receive the control signal to control the on/off state of the first switching transistor, and the filter device may filter the control signal.

### BRIEF DESCRIPTION OF DRAWINGS

FIG. 1 is a schematic of a circuit structure of a power converter according to an embodiment of this application;
FIG. 2 is a schematic of a circuit structure of a power converter according to Embodiment 1;
FIG. 3a is a schematic of another circuit structure of a power converter according to Embodiment 1;
FIG. 3b is a schematic of another circuit structure of a power converter according to Embodiment 1;
FIG. 4 is a schematic of a circuit structure of a power converter according to Embodiment 2;
FIG. 5a is a schematic of another circuit structure of a power converter according to Embodiment 2;
FIG. 5b is a schematic of another circuit structure of a power converter according to Embodiment 2;
FIG. 6 is a schematic of a circuit structure of a power converter according to Embodiment 3;
FIG. 7a is a schematic of another circuit structure of a power converter according to Embodiment 3;
FIG. 7b is a schematic of another circuit structure of a power converter according to Embodiment 3; and
FIG. 7c is a schematic of another circuit structure of a power converter according to Embodiment 3.

### DESCRIPTION OF EMBODIMENTS

To make objectives, technical solutions, and advantages of this application clearer, the following further describes this application in detail with reference to the accompanying drawings. However, example implementations may be implemented in a plurality of forms and should not be construed as being limited to implementations described herein. On the contrary, these implementations are provided such that this application is more comprehensive and complete and fully conveys the concept of the example implementations to a person skilled in the art. Identical reference numerals in the accompanying drawings denote identical or similar structures. Therefore, repeated description thereof is omitted. Words that express a position and a direction and that are described in this application are all descriptions provided by using the accompanying drawings as examples, but changes may alternatively be made as required, and all the made changes fall within the protection scope of this application. The accompanying drawings in this application are used merely to illustrate a relative position relationship and do not represent an actual scale.

It should be noted that specific details are set forth in the following descriptions for ease of fully understanding this application. However, this application can be implemented in a plurality of manners different from those described herein, and a person skilled in the art can perform similar promotion without departing from the connotation of this application. Therefore, this application is not limited to the specific implementations disclosed below. The following descriptions of this specification are example implementations of this application. However, the descriptions are intended to describe the general principle of this application, and are not intended to limit the scope of this application. The protection scope of this application shall be defined by the appended claims.

To facilitate understanding of embodiments of this application, the following first describes related technologies in embodiments of this application.

Terms used in the following embodiments are merely intended to describe specific embodiments, but are not intended to limit this application. Terms "one", "a", and "this" of singular forms used in this specification and the appended claims of this application are also intended to include expressions such as "one or more", unless otherwise specified in the context clearly. It may be further understood that, in the following embodiments of this application, "at least one" means one, two, or more.

Reference to "an embodiment" or the like described in this specification means that one or more embodiments of this application include a particular feature, structure, or characteristic described in combination with the embodiment. Therefore, statements such as "in an embodiment", "in some embodiments", and "in other embodiments" that appear at different places in this specification do not necessarily mean referring to a same embodiment. Instead, the statements mean referring to "one or more but not all of embodiments", unless otherwise specifically emphasized in another manner. The terms "include", "have", and their variants all mean "including but not limited to", unless otherwise specifically emphasized in another manner.

In a conventional technology, when a drive voltage output by a drive circuit is not changed, a value of a drive resistance of a line between the drive circuit and a control end of a switching transistor is changed in a manner of connecting a resistor switching control circuit in series on an output loop of the drive circuit, thereby changing a drive voltage input to the control end of the switching transistor, and further controlling a switching speed of the switching transistor. For some switching transistors with large drive internal resistances, a manner of changing the drive resistance can only slow down a switching speed of the switching transistor, but cannot increase the switching speed of the switching transistor. In addition, because a plurality of switching transistors cannot share a drive resistor, when the plurality of switching transistors are used in a power converter, a resistor switching control circuit needs to be added for each switching transistor, which may result in a significant increase in costs.

In view of this, in a power converter provided in this application, a controllable voltage regulator circuit connected in parallel to a drive power supply is added to a drive circuit. In this way, in different input voltage conditions, a connected state and a disconnected state of the voltage regulator circuit are switched, that is, whether to form a parallel connection relationship with the drive power supply by switching the state of the voltage regulator circuit, to control change of a drive voltage output by the drive circuit, thereby changing a switching speed of a switching transistor.

The power converter provided in this application is applicable to a power conversion scenario in which an input voltage range is wide. For example, the power converter is used as a photovoltaic inverter to convert a direct current input by a photovoltaic module into an alternating current for output, and the power converter is used as a direct current-to-direct current (DC-to-DC) power supply.

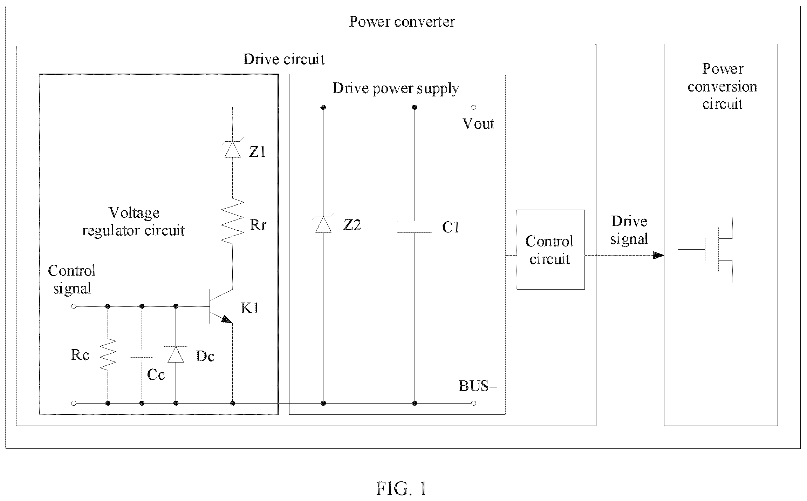

With reference to FIG. 1, the power converter provided in this application specifically includes a power conversion circuit and a drive circuit. The power conversion circuit includes at least one switching transistor, the drive circuit is configured to send a drive signal to the switching transistor in the power conversion circuit, and the drive signal is used to control an on/off state of the switching transistor. The drive circuit specifically includes a drive power supply, a voltage regulator circuit, and a control circuit. The drive power supply includes a power supply voltage output end Vout and a reference voltage output end BUS-. The drive power supply is configured to provide a power supply voltage between the power supply voltage output end Vout and the reference voltage output end BUS-. Specifically, the power supply voltage is provided to the control circuit. The control circuit generates a turn-on/turn-off voltage of the drive signal based on the power supply voltage. The control circuit sends the drive signal to a control end of the switching transistor, to control the on/off state of the switching transistor. The voltage regulator circuit includes a first switching transistor K1 and a first voltage regulator diode Z1, and the first switching transistor K1 and the first voltage regulator diode Z1 are connected in series between the power supply voltage output end Vout and the reference voltage output end BUS-. The voltage regulator circuit is configured to: change a voltage value of the power supply voltage and stabilize the voltage value of the power supply voltage. Specifically, when the first switching transistor K1 is turned off, the voltage regulator circuit is in a disconnected state, that is, the first voltage regulator diode Z1 is floating-disposed, so that the output power supply voltage between the power supply voltage output end Vout and the reference voltage output end BUS- is kept at a rated fixed value or within a defined range. When the first switching transistor K1 is turned on, the voltage regulator circuit is in a connected state, that is, the first voltage regulator diode Z1 and the drive power supply form a parallel connection relationship, so that the voltage value of the output power supply voltage between the power supply voltage output end Vout and the reference voltage output end BUS- is changed to a fixed voltage regulator value of the first voltage regulator diode Z1, to change the output power supply voltage and stabilize the power supply voltage to the fixed value. This drives a change of the turn-on/turn-off voltage of the drive signal based on the change of the power supply voltage, to change a switching speed of the switching transistor in the power conversion circuit. Specifically, in a working condition of a high input voltage, the power supply voltage is changed to reduce the turn-on/turn-off voltage of the drive signal, so that a peak voltage of the switching transistor may be reduced; or in a working condition of a low input voltage, the power supply voltage is changed to increase the turn-on/turn-off voltage of the drive signal, so that a switching speed of the switching transistor may be increased and a loss may be reduced.

With reference to FIG. 1, in some embodiments of this application, to stabilize the power supply voltage to a fixed value when the voltage regulator circuit is in a disconnected state, the drive power supply may further include a second voltage regulator diode Z2 and a voltage divider capacitor C1 that are connected in parallel between the power supply voltage output end Vout and the reference voltage output end BUS-, and a voltage regulator value of the second voltage regulator diode Z2 needs to be greater than the voltage regulator value of the first voltage regulator diode Z1. When the first switching transistor K1 is turned off, the voltage value of the power supply voltage is the voltage regulator value of the second voltage regulator diode Z2. In this way, when the first switching transistor K1 is turned off, the voltage regulator circuit is in the disconnected state, that is, the first voltage regulator diode Z1 is floating-disposed, so that the second voltage regulator diode Z2 keeps the output power supply voltage between the power supply voltage output end Vout and the reference voltage output end BUS- at a fixed voltage regulator value of the second voltage regulator diode Z2. When the first switching transistor K1 is turned on, the voltage regulator circuit is in the connected state, that is, the first voltage regulator diode Z1 and the drive power supply form the parallel connection relationship, so that the output power supply voltage between the power supply voltage output end Vout and the reference voltage output end BUS- is changed to the fixed voltage regulator value of the first voltage regulator diode Z1. The on/off state of the first switching transistor K1 is changed, to change the output power supply voltage and stabilize the output power supply voltage. This drives the change of the turn-on/turn-off voltage of the drive signal based on the change of the power supply voltage, to change the switching speed of the switching transistor in the power conversion circuit.

With reference to FIG. 1, in some embodiments of this application, the voltage regulator circuit may usually further include a current-limiting resistor Rr. The current-limiting resistor Rr is connected in series between the first switching transistor K1 and the first voltage regulator diode Z1, to limit a current flowing through the first switching transistor K1, and protect the first switching transistor K1 from overcurrent.

With reference to FIG. 1, in some embodiments of this application, the voltage regulator circuit may usually further include a filter device. The filter device is connected to a control end of the first switching transistor K1, and the filter device includes at least one of a filter capacitor Cc, a filter resistor Rc, and a filter diode Dc. Specifically, the control end of the first switching transistor K1 is configured to receive the control signal to control the on/off state of the first switching transistor K1, and the filter device may filter the control signal.

In this application, a type of the power supply voltage that needs to be stabilized and controlled may be determined based on a type of the switching transistor used in the power conversion circuit. For example, when the switching transistor is an IGBT, a turn-on voltage of the drive signal is a positive voltage, and a turn-off voltage of the drive signal is a negative voltage. The drive power supply needs to provide a positive power supply voltage V1 between a positive voltage output end VCC and the reference voltage output end BUS-, and the control circuit generates the turn-on voltage of the IGBT drive signal based on the positive power supply voltage V1. In addition, the drive power supply further needs to provide a negative power supply voltage V2 between a negative voltage output end VEE and the reference voltage output end BUS-, and the control circuit generates the turn-off voltage of the IGBT drive signal based on the negative power supply voltage V2. According to a requirement, change of the positive power supply voltage V1 may be independently controlled and the positive power supply voltage V1 may be stabilized, or change of the negative power supply voltage V2 may be independently controlled and the negative power supply voltage V2 may be stabilized, or both the positive power supply voltage V1 and the negative power supply voltage V2 may be controlled. For another example, when the switching transistor is an N-type MOSFET, a turn-on voltage of an NMOS drive signal is a positive voltage, and a turn-off voltage of the NMOS drive signal is a reference voltage. The drive power supply needs to provide only a positive power supply voltage V1 between a positive voltage output end VCC and the reference voltage output end BUS-, and the control circuit generates the turn-on voltage of the NMOS drive signal based on the positive power supply voltage V1. According to a requirement, change of the positive power supply voltage V1 may be independently controlled and the positive power supply voltage V1 may be stabilized. When the switching transistor is a P-type MOSFET, a turn-on voltage of a PMOS drive signal is a negative voltage, and a turn-off voltage of the PMOS drive signal is a reference voltage. The drive power supply needs to provide only a negative power supply voltage V2 between a negative voltage output end VEE and the reference voltage output end BUS-, and the control circuit generates the turn-on voltage of the PMOS drive signal based on the negative power supply voltage V2. According to a requirement, change of the negative power supply voltage V2 may be independently controlled and the negative power supply voltage V2 may be stabilized.

The following uses examples to describe the power converter provided in embodiments of this application based on different types of power supply voltages that need to be controlled.

### Embodiment 1:

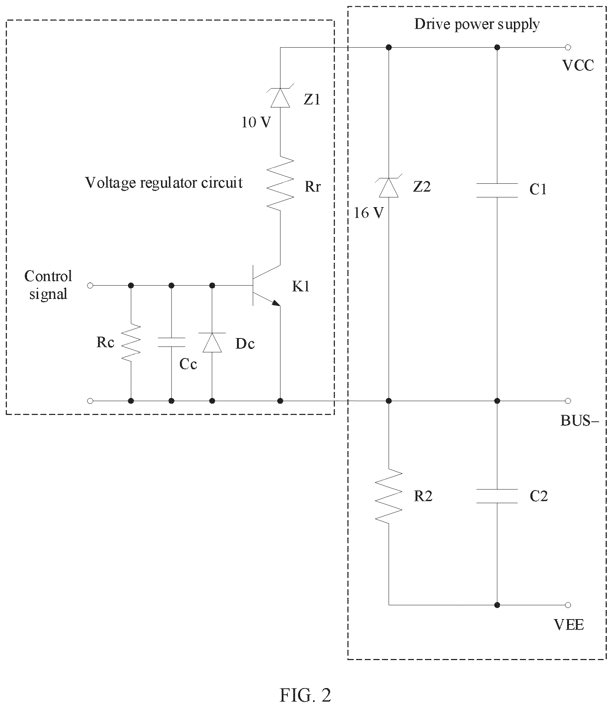

With reference to FIG. 2, in this embodiment, the power supply voltage output end Vout specifically includes the positive voltage output end VCC, the drive power supply is configured to provide the positive power supply voltage V1 between the positive voltage output end VCC and the reference voltage output end BUS-, and the control circuit generates the turn-on voltage of the drive signal based on the positive power supply voltage V1. The voltage regulator circuit may specifically perform voltage change and stabilization on the positive power supply voltage V1, to change the turn-on voltage of the drive signal. Specifically, the first switching transistor K1 and the first voltage regulator diode Z1 are connected in series between the positive voltage output end VCC and the reference voltage output end BUS-, the second voltage regulator diode Z2 and the voltage divider capacitor C1 are connected in parallel between the positive voltage output end VCC and the reference voltage output end BUS-, and the filter device may be connected between the control end of the first switching transistor K1 and the reference voltage output end BUS-. The voltage regulator value of the first voltage regulator diode Z1 is less than the voltage regulator value of the second voltage regulator diode Z2. For example, the first voltage regulator diode Z1 may be a voltage regulator diode with a voltage regulator value being 10 V, and the second voltage regulator diode Z2 may be a voltage regulator diode with a voltage regulator value being 16 V. When the first switching transistor K1 is turned off, the voltage regulator circuit is in the disconnected state, that is, the first voltage regulator diode Z1 is floating-disposed, so that the second voltage regulator diode Z2 keeps the positive power supply voltage V1 at the fixed voltage regulator value of the second voltage regulator diode Z2. Specifically, the positive power supply voltage V1 is stabilized at the voltage regulator value of the second voltage regulator diode Z2, namely, V1 = 16 V. When the first switching transistor K1 is turned on, the voltage regulator circuit is in the connected state, that is, the first voltage regulator diode Z1 and the second voltage regulator diode Z2 form a parallel connection relationship, so that the positive power supply voltage V1 is changed to the fixed voltage regulator value of the first voltage regulator diode Z1. Specifically, the positive power supply voltage V1 is changed to and stabilized at the voltage regulator value of the first voltage regulator diode Z1, namely, V1 = 10 V. In this way, voltage change and stabilization of the positive power supply voltage V1 are implemented, to change and stabilize the turn-on voltage of the drive signal. For example, when a turn-on peak voltage is high, the first voltage regulator diode Z1 is connected by turning on the first switching transistor K1, so that the positive power supply voltage V1 can be reduced, thereby reducing the turn-on voltage of the drive signal, to reduce the turn-on peak voltage of the switching transistor. When a loss needs to be reduced, the first voltage regulator diode Z1 is floating-disposed by turning off the first switching transistor K1, so that the positive power supply voltage V1 can be increased, thereby increasing the turn-on voltage of the drive signal, to increase a turn-on speed of the switching transistor and reduce the loss.

With reference to FIG. 2, in this embodiment, if the power conversion circuit uses the IGBT as the switching transistor, the power supply voltage output end Vout further needs to include the negative voltage output end VEE, the drive power supply further needs to provide the negative power supply voltage V2 between the negative voltage output end VEE and the reference voltage output end BUS-, and the control circuit generates the turn-off voltage of the drive signal based on the negative power supply voltage V2. A voltage difference between the positive voltage output end VCC and the negative voltage output end VEE is a fixed value, for example, may be 25 V. The negative power supply voltage V2 changes as the positive power supply voltage V1 changes. In this case, the drive power supply may further include a voltage divider resistor R2 and a voltage divider capacitor C2 that are connected in parallel between the negative voltage output end VEE and the reference voltage output end BUS-. When the first switching transistor K1 is turned off, and the positive power supply voltage V1 is stabilized at the voltage regulator value of the second voltage regulator diode Z2, namely, V1 = 16 V, the negative power supply voltage V2 = -(VCC - VEE - 16 V) = -9 V. When the first switching transistor K1 is turned on, and the positive power supply voltage V1 is changed to and stabilized at the voltage regulator value of the first voltage regulator diode Z1, namely, V1 = 10 V, the negative power supply voltage V2 = -(VCC - VEE - 10 V) = -15 V. The negative power supply voltage V2 decreases as the positive power supply voltage V1 decreases. When the first voltage regulator diode Z1 is connected by turning on the first switching transistor K1, on the basis of reducing the positive power supply voltage V1 and reducing the turn-on voltage of the drive signal to reduce the turn-on peak voltage of the switching transistor, the negative power supply voltage V2 may be reduced and the turn-off voltage of the drive signal may be reduced to increase a turn-off speed of the switching transistor. When the first voltage regulator diode Z1 is floating-disposed by turning off the first switching transistor K1, on the basis of increasing the positive power supply voltage V1 and increasing the turn-on voltage of the drive signal to increase the turn-on speed of the switching transistor and reduce the loss, the negative power supply voltage V2 may be increased and the turn-off voltage of the drive signal may be increased to reduce a turn-off peak voltage of the switching transistor.

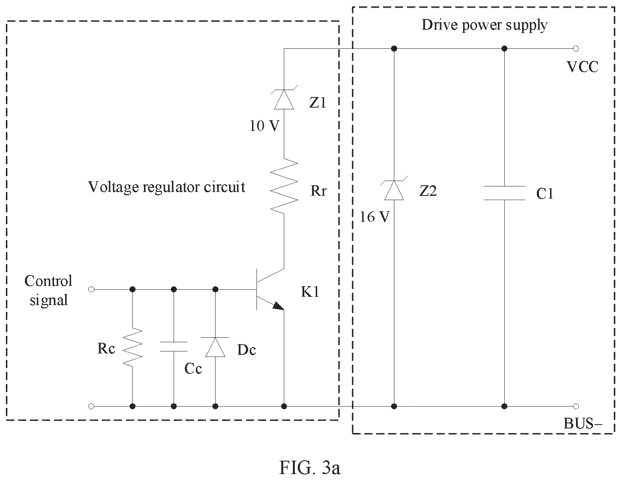

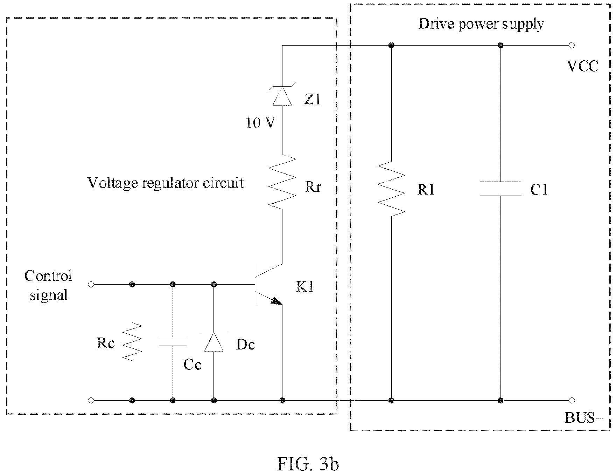

With reference to FIG. 3a and FIG. 3b, in this embodiment, if the power conversion circuit uses the NMOS as the switching transistor, the power supply voltage output end Vout may include only the positive voltage output end VCC, the drive power supply is only configured to provide the positive power supply voltage V1 between the positive voltage output end VCC and the reference voltage output end BUS-, the control circuit generates the turn-on voltage of the drive signal based on the positive power supply voltage V1, and the turn-off voltage of the drive signal may be directly provided by the reference voltage output end BUS-.

Specifically, with reference to FIG. 3a, the drive power supply may include the second voltage regulator diode Z2 and the voltage divider capacitor C1 that are connected in parallel between the positive voltage output end VCC and the reference voltage output end BUS-. In addition, the voltage regulator value of the second voltage regulator diode Z2 needs to be greater than the voltage regulator value of the first voltage regulator diode Z1. For example, the first voltage regulator diode Z1 may be a voltage regulator diode with a voltage regulator value being 10 V, and the second voltage regulator diode Z2 may be a voltage regulator diode with a voltage regulator value being 16 V. When the first switching transistor K1 is turned off, the first voltage regulator diode Z1 is floating-disposed, so that the second voltage regulator diode Z2 keeps the positive power supply voltage V1 at the fixed voltage regulator value of the second voltage regulator diode Z2. Specifically, the positive power supply voltage V1 is stabilized at the voltage regulator value of the second voltage regulator diode Z2, namely, V1 = 16 V. When the first switching transistor K1 is turned on, the first voltage regulator diode Z1 and the second voltage regulator diode Z2 form the parallel connection relationship, so that the positive power supply voltage V1 is changed to the fixed voltage regulator value of the first voltage regulator diode Z1. Specifically, the positive power supply voltage V1 is changed to and stabilized at the voltage regulator value of the first voltage regulator diode Z1, namely, V1 = 10 V. In this way, voltage change and stabilization of the positive power supply voltage V1 are implemented, to change and stabilize the turn-on voltage of the drive signal. For example, when a turn-on peak voltage is high, the first voltage regulator diode Z1 is connected by turning on the first switching transistor K1, so that the positive power supply voltage V1 can be reduced, thereby reducing the turn-on voltage of the drive signal, to reduce the turn-on peak voltage of the switching transistor. When a loss needs to be reduced, the first voltage regulator diode Z1 is floating-disposed by turning off the first switching transistor K1, so that the positive power supply voltage V1 can be increased, thereby increasing the turn-on voltage of the drive signal, to increase a turn-on speed of the switching transistor and reduce the loss.

Alternatively, with reference to FIG. 3b, the drive power supply may include a voltage divider resistor R1 and the voltage divider capacitor C1 that are connected in parallel between the positive voltage output end VCC and the reference voltage output end BUS-. For example, the first voltage regulator diode Z1 may be a voltage regulator diode with a voltage regulator value being 10 V, a voltage of the positive voltage output end VCC is 16 V but actually floats between 15 V and 17 V, and a voltage of the reference voltage output end BUS- is set to 0 V. When the first switching transistor K1 is turned off, the first voltage regulator diode Z1 is floating-disposed, and the positive power supply voltage V1 floats between 15 V and 17 V. When the first switching transistor K1 is turned on, the first voltage regulator diode Z1 forms a parallel connection relationship with the voltage divider resistor R1 and the voltage divider capacitor C1, so that the positive power supply voltage V1 is changed to the fixed voltage regulator value of the first voltage regulator diode Z1. Specifically, the positive power supply voltage V1 is changed to and stabilized at the voltage regulator value of the first voltage regulator diode Z1, namely, V1 = 10 V. In this way, voltage change and stabilization of the positive power supply voltage V1 are implemented, to change and stabilize the turn-on voltage of the drive signal. For example, when a turn-on peak voltage is high, the first voltage regulator diode Z1 is connected by turning on the first switching transistor K1, so that the positive power supply voltage V1 can be reduced, thereby reducing the turn-on voltage of the drive signal, to reduce the turn-on peak voltage of the switching transistor. When a loss needs to be reduced, the first voltage regulator diode Z1 is floating-disposed by turning off the first switching transistor K1, so that the positive power supply voltage V1 can be increased, thereby increasing the turn-on voltage of the drive signal, to increase a turn-on speed of the switching transistor and reduce the loss.

### Embodiment 2:

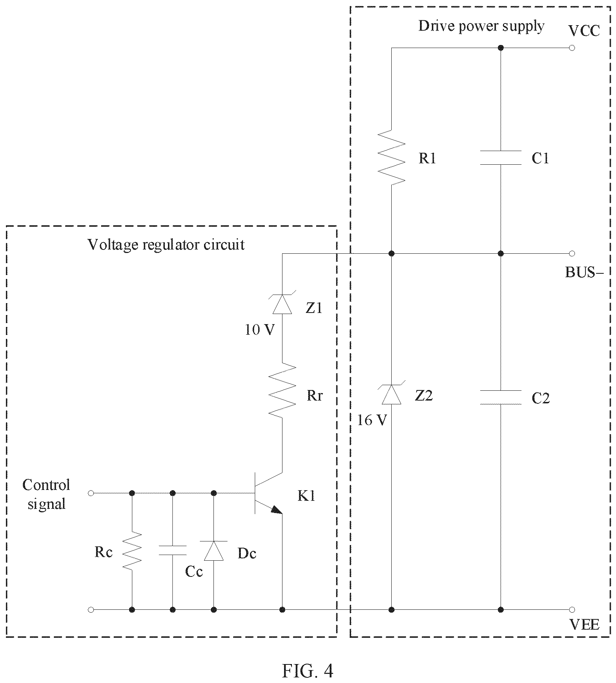

With reference to FIG. 4, in this embodiment, the power supply voltage output end Vout specifically includes the negative voltage output end VEE, the drive power supply is configured to provide the negative power supply voltage V2 between the negative voltage output end VEE and the reference voltage output end BUS-, and the control circuit generates the turn-off voltage of the drive signal based on the negative power supply voltage V2. The voltage regulator circuit may specifically perform voltage change and stabilization on the negative power supply voltage V2, to change the turn-off voltage of the drive signal. Specifically, the first switching transistor K1 and the first voltage regulator diode Z1 are connected in series between the negative voltage output end VEE and the reference voltage output end BUS-, the second voltage regulator diode Z2 and a voltage divider capacitor C2 are connected in parallel between the negative voltage output end VEE and the reference voltage output end BUS-, and the filter device may be connected between the control end of the first switching transistor K1 and the negative voltage output end VEE. The voltage regulator value of the first voltage regulator diode Z1 is less than the voltage regulator value of the second voltage regulator diode Z2. For example, the first voltage regulator diode Z1 may be a voltage regulator diode with a voltage regulator value being 10 V, and the second voltage regulator diode Z2 may be a voltage regulator diode with a voltage regulator value being 16 V. When the first switching transistor K1 is turned off, the voltage regulator circuit is in the disconnected state, that is, the first voltage regulator diode Z1 is floating-disposed, so that the second voltage regulator diode Z2 keeps the negative power supply voltage V2 at the fixed voltage regulator value of the second voltage regulator diode Z2. Specifically, the negative power supply voltage V2 is stabilized at the voltage regulator value of the second voltage regulator diode Z2, namely, V2 = -16 V. When the first switching transistor K1 is turned on, the voltage regulator circuit is in the connected state, that is, the first voltage regulator diode Z1 and the second voltage regulator diode Z2 form a parallel connection relationship, so that the negative power supply voltage V2 is changed to the fixed voltage regulator value of the first voltage regulator diode Z1. Specifically, the negative power supply voltage V2 is changed to and stabilized at the voltage regulator value of the first voltage regulator diode Z1, namely, V2 = -10 V. In this way, voltage change and stabilization of the negative power supply voltage V2 are implemented, to change and stabilize the turn-off voltage of the drive signal. For example, when a turn-off peak voltage is high, the first voltage regulator diode Z1 is connected by turning on the first switching transistor K1, so that an absolute value of the negative power supply voltage V2 can be reduced, thereby reducing an absolute value of the turn-off voltage of the drive signal, to reduce the turn-off peak voltage of the switching transistor. When a loss needs to be reduced, the first voltage regulator diode Z1 is floating-disposed by turning off the first switching transistor K1, so that the absolute value of the negative power supply voltage V2 can be increased, thereby increasing the absolute value of the turn-off voltage of the drive signal, to increase a turn-off speed of the switching transistor and reduce the loss.

With reference to FIG. 4, in this embodiment, if the power conversion circuit uses the IGBT as the switching transistor, the power supply voltage output end Vout further needs to include the positive voltage output end VCC, the drive power supply further needs to provide the positive power supply voltage V1 between the positive voltage output end VCC and the reference voltage output end BUS-, and the control circuit generates the turn-on voltage of the drive signal based on the positive power supply voltage V1. A voltage difference between the positive voltage output end VCC and the negative voltage output end VEE is a fixed value, for example, may be 25 V. The positive power supply voltage V1 changes as the negative power supply voltage V2 changes. In this case, the drive power supply may further include a voltage divider resistor R1 and the voltage divider capacitor C1 that are connected in parallel between the positive voltage output end VCC and the reference voltage output end BUS-. When the first switching transistor K1 is turned off, and the negative power supply voltage V2 is stabilized at the voltage regulator value of the second voltage regulator diode Z2, namely, V2 = -16 V, the positive power supply voltage V1 = VCC - VEE - 16 V = 9 V. When the first switching transistor K1 is turned on, and the negative power supply voltage V2 is changed to and stabilized at the voltage regulator value of the first voltage regulator diode Z1, namely, V2 = -10 V, the positive power supply voltage V1 = VCC - VEE - 10 V = 15 V. The positive power supply voltage V1 increases as the negative power supply voltage V2 increases. When the first voltage regulator diode Z1 is connected by turning on the first switching transistor K1, on the basis of increasing the negative power supply voltage V2 and increasing the turn-on voltage of the drive signal to reduce the turn-off peak voltage of the switching transistor, the positive power supply voltage V1 may be increased and the turn-on voltage of the drive signal may be increased to increase a turn-on speed of the switching transistor. When the first voltage regulator diode Z1 is floating-disposed by turning off the first switching transistor K1, on the basis of reducing the negative power supply voltage V2 and reducing the turn-off voltage of the drive signal to increase the turn-off speed of the switching transistor and reduce the loss, the positive power supply voltage V1 may be increased and the turn-on voltage of the drive signal may be increased to reduce a turn-on peak voltage of the switching transistor.

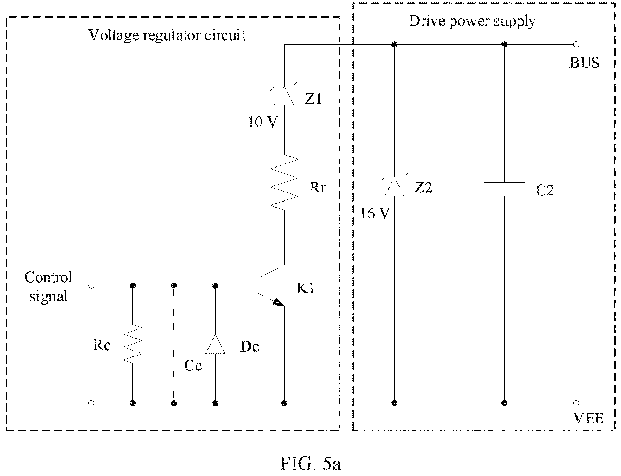

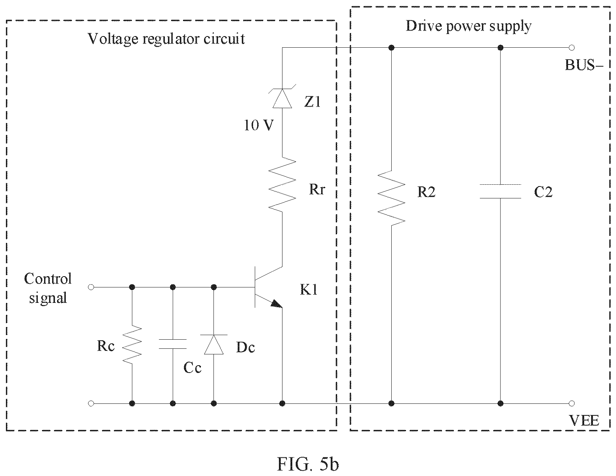

With reference to FIG. 5a and FIG. 5b, in this embodiment, if the power conversion circuit uses the PMOS as the switching transistor, the power supply voltage output end Vout may include only the negative voltage output end VEE, the drive power supply is only configured to provide the negative power supply voltage V2 between the negative voltage output end VEE and the reference voltage output end BUS-, the control circuit generates the turn-on voltage of the drive signal based on the negative power supply voltage V2, and the turn-off voltage of the drive signal may be directly provided by the reference voltage output end BUS-.

Specifically, with reference to FIG. 5a, the drive power supply may include the second voltage regulator diode Z2 and the voltage divider capacitor C2 that are connected in parallel between the negative voltage output end VEE and the reference voltage output end BUS-. In addition, the voltage regulator value of the second voltage regulator diode Z2 needs to be greater than the voltage regulator value of the first voltage regulator diode Z1. For example, the first voltage regulator diode Z1 may be a voltage regulator diode with a voltage regulator value being 10 V, and the second voltage regulator diode Z2 may be a voltage regulator diode with a voltage regulator value being 16 V. When the first switching transistor K1 is turned off, the first voltage regulator diode Z1 is floating-disposed, so that the second voltage regulator diode Z2 keeps the negative power supply voltage V2 at the fixed voltage regulator value of the second voltage regulator diode Z2. Specifically, the negative power supply voltage V2 is stabilized at the voltage regulator value of the second voltage regulator diode Z2, namely, V2 = -16 V. When the first switching transistor K1 is turned on, the first voltage regulator diode Z1 and the second voltage regulator diode Z2 form the parallel connection relationship, so that the negative power supply voltage V2 is changed to the fixed voltage regulator value of the first voltage regulator diode Z1. Specifically, the negative power supply voltage V2 is changed to and stabilized at the voltage regulator value of the first voltage regulator diode Z1, namely, V2 = -10 V. In this way, voltage change and stabilization of the negative power supply voltage V2 are implemented, to change and stabilize the turn-on voltage of the drive signal. For example, when a turn-on peak voltage is high, the first voltage regulator diode Z1 is connected by turning on the first switching transistor K1, so that the negative power supply voltage V2 can be reduced, thereby reducing the turn-on voltage of the drive signal, to reduce the turn-on peak voltage of the switching transistor. When a loss needs to be reduced, the first voltage regulator diode Z1 is floating-disposed by turning off the first switching transistor K1, so that the negative power supply voltage V2 can be increased, thereby increasing the turn-on voltage of the drive signal, to increase a turn-on speed of the switching transistor and reduce the loss.

Alternatively, with reference to FIG. 5b, the drive power supply may include a voltage divider resistor R2 and the voltage divider capacitor C2 that are connected in parallel between the negative voltage output end VEE and the reference voltage output end BUS-. For example, the first voltage regulator diode Z1 may be a voltage regulator diode with a voltage regulator value being 10 V, a voltage of the negative voltage output end VEE is -16 V but actually floats between -17 V and -15 V, and a voltage of the reference voltage output end BUS- is set to 0 V. When the first switching transistor K1 is turned off, the first voltage regulator diode Z1 is floating-disposed, and the negative power supply voltage V2 floats between -17 V and -15 V. When the first switching transistor K1 is turned on, the first voltage regulator diode Z1 forms a parallel connection relationship with the voltage divider resistor R2 and the voltage divider capacitor C2, so that the negative power supply voltage V2 is changed to the fixed voltage regulator value of the first voltage regulator diode Z1. Specifically, the negative power supply voltage V2 is changed to and stabilized at the voltage regulator value of the first voltage regulator diode Z1, namely, V2 = -10 V. In this way, voltage change and stabilization of the negative power supply voltage V2 are implemented, to change and stabilize the turn-on voltage of the drive signal. For example, when a turn-on peak voltage is high, the first voltage regulator diode Z1 is connected by turning on the first switching transistor K1, so that the negative power supply voltage V2 can be reduced, thereby reducing the turn-on voltage of the drive signal, to reduce the turn-on peak voltage of the switching transistor. When a loss needs to be reduced, the first voltage regulator diode Z1 is floating-disposed by turning off the first switching transistor K1, so that the negative power supply voltage V2 can be increased, thereby increasing the turn-on voltage of the drive signal, to increase a turn-on speed of the switching transistor and reduce the loss.

### Embodiment 3:

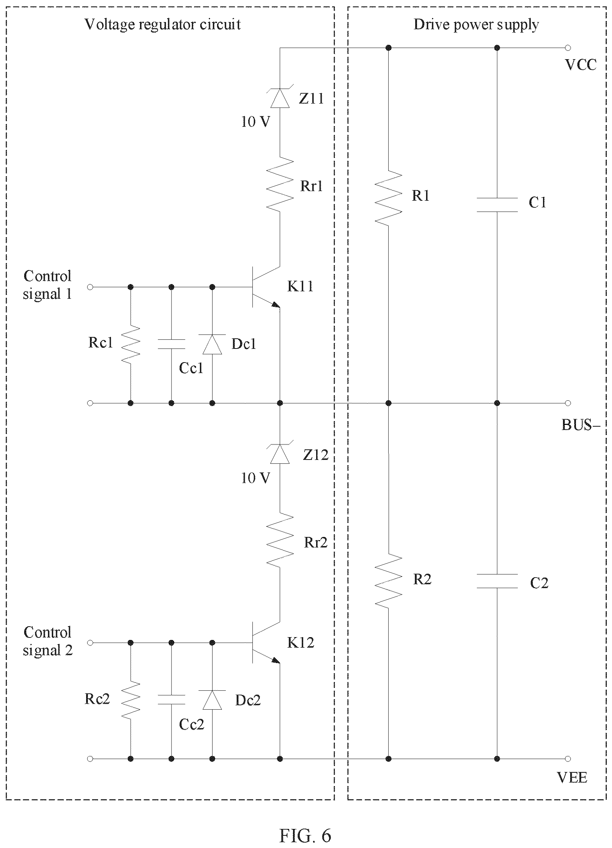

With reference to FIG. 6, in this embodiment, the power supply voltage output end Vout specifically includes a positive voltage output end VCC and a negative voltage output end VEE. The drive power supply is configured to: provide a positive power supply voltage V1 between the positive voltage output end VCC and the reference voltage output end BUS-, and provide a negative power supply voltage V2 between the negative voltage output end VEE and the reference voltage output end BUS-. The control circuit generates the turn-on voltage of the drive signal based on the positive power supply voltage V1, and the control circuit generates the turn-off voltage of the drive signal based on the negative power supply voltage V2. The voltage regulator circuit includes two groups including first switching transistors K1 and first voltage regulator diodes Z1. One group including a first switching transistor K11 and a first voltage regulator diode Z11 is connected in series between the positive voltage output end VCC and the reference voltage output end BUS-, and a corresponding filter device may be connected between a control end of the first switching transistor K11 and the reference voltage output end BUS-. The other group including a first switching transistor K12 and a first voltage regulator diode Z12 is connected in series between the negative voltage output end VEE and the reference voltage output end BUS-, and a corresponding filter device may be connected between a control end of the first switching transistor K12 and the negative voltage output end VEE. Voltage regulator values of the first voltage regulator diodes Z11 and Z12 may be set to any value according to a requirement, and the voltage regulator values of the first voltage regulator diodes Z11 and Z12 may be the same or different. For example, the first voltage regulator diode Z11 may be a voltage regulator diode with a voltage regulator value being 10 V, and the first voltage regulator diode Z12 may also be a voltage regulator diode with a voltage regulator value being 10 V. A voltage difference between the positive voltage output end VCC and the negative voltage output end VEE is a fixed value, for example, may be 25 V. When the first switching transistor K11 is turned on and the first switching transistor K12 is turned off, the first voltage regulator diode Z12 is floating-disposed, and the first voltage regulator diode Z11 controls the positive power supply voltage V1 to be a fixed voltage regulator value of the first voltage regulator diode Z11. Specifically, the positive power supply voltage V1 is stabilized at the voltage regulator value of the first voltage regulator diode Z11, namely, V1 = 10 V. In this way, voltage change and stabilization of the positive power supply voltage V1 are implemented, to change and stabilize the turn-on voltage of the drive signal. When the first switching transistor K11 is turned off and the first switching transistor K12 is turned on, the first voltage regulator diode Z11 is floating-disposed, and the first voltage regulator diode Z12 controls the negative power supply voltage V2 to be a fixed voltage regulator value of the first voltage regulator diode Z12. Specifically, the negative power supply voltage V2 is changed to and stabilized at the voltage regulator value of the first voltage regulator diode Z12, namely, V2 = -10 V. In this way, voltage change and stabilization of the negative power supply voltage V2 are implemented, to change and stabilize the turn-off voltage of the drive signal. When both the first switching transistors K11 and K12 are turned on, the first voltage regulator diode Z11 controls the positive power supply voltage V1 to be a fixed value, namely, V1 = 10 V, and the first voltage regulator diode Z12 controls the negative power supply voltage V2 to be a fixed value, namely, V2 = -10 V. In this way, voltage change and stabilization of the positive power supply voltage V1 and the negative power supply voltage V2 are implemented at the same time, to change and stabilize the turn-on/turn-off voltage of the drive signal.

With reference to FIG. 6, in this embodiment, the drive power supply may further include two groups including voltage divider resistors and voltage divider capacitors. One group including a voltage divider resistor R1 and a voltage divider capacitor C1 is connected in parallel between the positive voltage output end VCC and the reference voltage output end BUS-. In this way, when the positive power supply voltage V1 is controllable and stable, the negative power supply voltage V2 changes as the positive power supply voltage V1 changes. The other group including a voltage divider resistor R2 and a voltage divider capacitor C2 is connected in parallel between the negative voltage output end VEE and the reference voltage output end BUS-. In this way, when the negative power supply voltage V2 is controllable and stable, the positive power supply voltage V1 changes as the negative power supply voltage V2 changes. Specifically, when the first switching transistor K11 is turned on, the first switching transistor K12 is turned off, and the positive power supply voltage V1 is stabilized at the voltage regulator value of the first voltage regulator diode Z11, namely, V1 = 10 V, the negative power supply voltage V2 = -(VCC - VEE - 10 V) = - 15 V. When the first switching transistor K11 is turned off, the first switching transistor K12 is turned on, and the negative power supply voltage V2 is stabilized at the voltage regulator value of the first voltage regulator diode Z12, namely, V2 = -10 V, the positive power supply voltage V1 = VCC - VEE - 10 V = 15 V. When the first switching transistor K11 is turned on and the first switching transistor K12 is turned off, the positive power supply voltage V1 may be reduced and the turn-on voltage of the drive signal may be reduced to reduce a turn-on peak voltage of the switching transistor, and the negative power supply voltage V2 may be reduced and the turn-off voltage of the drive signal may be reduced to increase a turn-off speed of the switching transistor. When the first switching transistor K11 is turned off and the first switching transistor K12 is turned on, the positive power supply voltage V1 may be increased and the turn-on voltage of the drive signal may be increased to increase a turn-on speed of the switching transistor and reduce a loss, and the negative power supply voltage V2 may be increased and the turn-off voltage of the drive signal may be increased to reduce a turn-off peak voltage of the switching transistor.

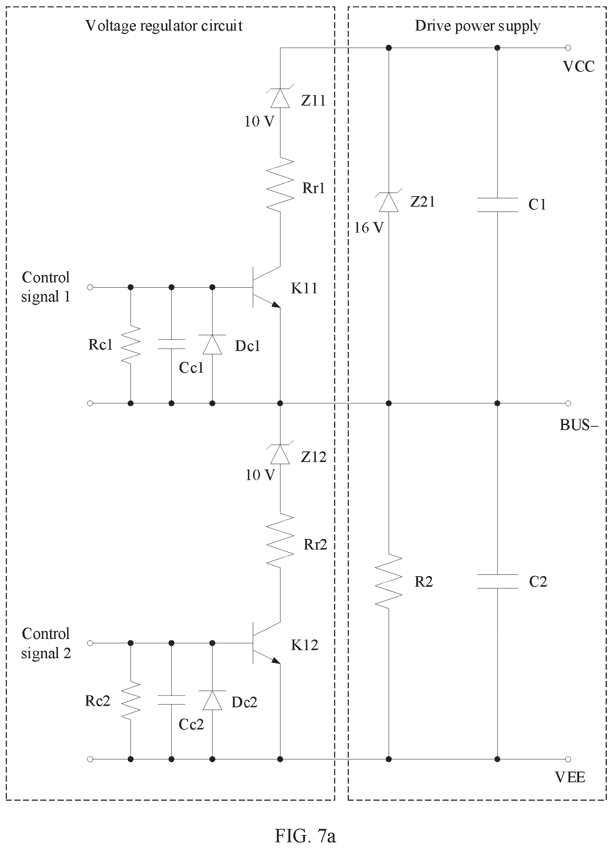

With reference to FIG. 7a, in this embodiment, the voltage divider resistor R1 connected between the positive voltage output end VCC and the reference voltage output end BUS- may alternatively be replaced with a second voltage regulator diode Z21. A voltage regulator value of the second voltage regulator diode Z21 is greater than the voltage regulator value of the first voltage regulator diode Z11. For example, the second voltage regulator diode Z21 may be a voltage regulator diode with a voltage regulator value being 16 V. When the first switching transistor K11 is turned off, the second voltage regulator diode Z21 may keep the positive power supply voltage V1 at a fixed voltage regulator value of the second voltage regulator diode Z21. Specifically, the positive power supply voltage V1 is stabilized at the voltage regulator value of the second voltage regulator diode Z21, namely, V1 = 16 V.

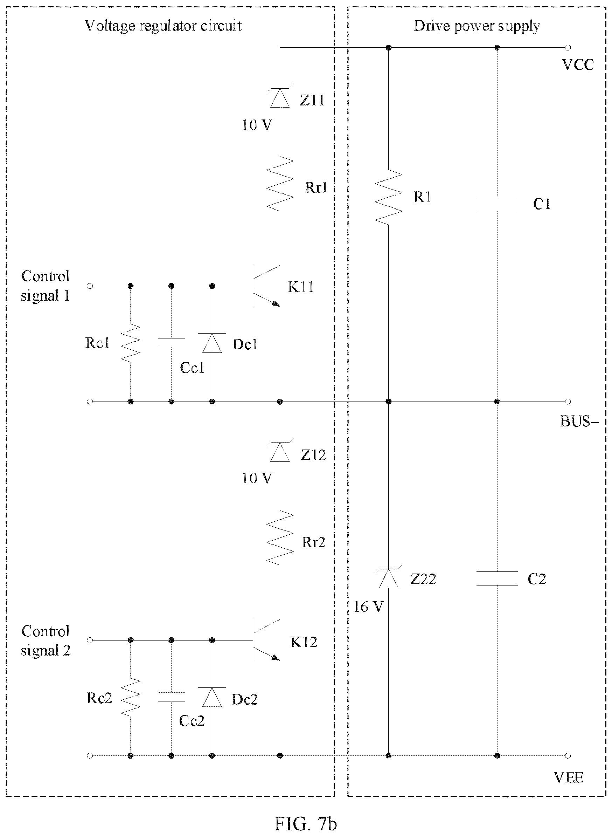

With reference to FIG. 7b, in this embodiment, the voltage divider resistor R2 connected between the negative voltage output end VEE and the reference voltage output end BUS- may alternatively be replaced with a second voltage regulator diode Z22. A voltage regulator value of the second voltage regulator diode Z22 is greater than the voltage regulator value of the first voltage regulator diode Z12. For example, the second voltage regulator diode Z22 may be a voltage regulator diode with a voltage regulator value being 16 V. When the first switching transistor K12 is turned off, the second voltage regulator diode Z22 may keep the negative power supply voltage V2 at a fixed voltage regulator value of the second voltage regulator diode Z22. Specifically, the negative power supply voltage V2 is stabilized at the voltage regulator value of the second voltage regulator diode Z22, namely, V2 = -16 V.

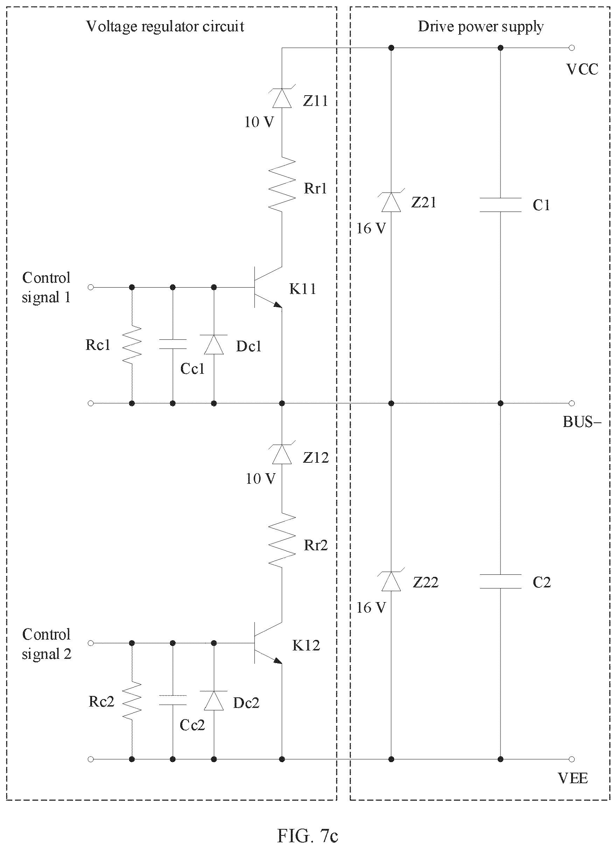

With reference to FIG. 7c, in this embodiment, the voltage divider resistor R1 connected between the positive voltage output end VCC and the reference voltage output end BUS- may alternatively be replaced with a second voltage regulator diode Z21, and the voltage divider resistor R2 connected between the negative voltage output end VEE and the reference voltage output end BUS- may alternatively be replaced with a second voltage regulator diode Z22. Voltage regulator values of the second voltage regulator diodes Z21 and Z22 are greater than the voltage regulator values of the first voltage regulator diodes Z11 and Z12. For example, the second voltage regulator diodes Z21 and Z22 may be voltage regulator diodes with a voltage regulator value being 16 V. When the first switching transistor K11 is turned off, the second voltage regulator diode Z21 may keep the positive power supply voltage V1 at a fixed voltage regulator value of the second voltage regulator diode Z21. Specifically, the positive power supply voltage V1 is stabilized at the voltage regulator value of the second voltage regulator diode Z21, namely, V1 = 16 V. When the first switching transistor K12 is turned off, the second voltage regulator diode Z22 may keep the negative power supply voltage V2 at a fixed voltage regulator value of the second voltage regulator diode Z22. Specifically, the negative power supply voltage V2 is stabilized at the voltage regulator value of the second voltage regulator diode Z22, namely, V2 = -16 V.

According to the power converter provided in this application, in the drive circuit, the drive power supply is connected in parallel to the voltage regulator circuit. The voltage regulator circuit includes the first switching transistor and the first voltage regulator diode that are connected in series between the power supply voltage output end and the reference voltage output end. The on/off state of the first switching transistor is controlled, so that the state of the first voltage regulator diode being connected to or disconnected from the drive power supply may be switched, thereby implementing voltage stabilization and change control of the power supply voltage provided by the drive power supply. The control circuit generates, based on the power supply voltage, the turn-on/turn-off voltage of the drive signal sent to the switching transistor in the power conversion circuit. Therefore, the power supply voltage can be changed to change the turn-on/turn-off voltage of the drive signal, thereby changing the switching speed of the switching transistor in the power conversion circuit. When the turn-on/turn-off voltage of the drive signal is reduced, the peak voltage of the switching transistor may be reduced. When the turn-on/turn-off voltage of the drive signal is increased, the switching speed of the switching transistor may be increased and the loss may be reduced.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter, comprising a power conversion circuit and a drive circuit, wherein the power conversion circuit comprises at least one switching transistor, and the drive circuit is configured to send a drive signal to the switching transistor in the power conversion circuit; and
the drive circuit comprises a drive power supply, a voltage regulator circuit, and a control circuit, wherein
the drive power supply comprises a power supply voltage output end and a reference voltage output end, the drive power supply is configured to provide a power supply voltage between the power supply voltage output end and the reference voltage output end to the control circuit, and the control circuit is configured to generate a turn-on/turn-off voltage of the drive signal based on the power supply voltage; and
the voltage regulator circuit comprises a first switching transistor and a first voltage regulator diode, and the first switching transistor and the first voltage regulator diode are connected in series between the power supply voltage output end and the reference voltage output end; and when the first switching transistor is turned on, a voltage value of the power supply voltage is a voltage regulator value of the first voltage regulator diode.

2. The power converter according to claim 1, wherein the drive power supply further comprises a second voltage regulator diode and a voltage divider capacitor that are connected in parallel between the power supply voltage output end and the reference voltage output end, and a voltage regulator value of the second voltage regulator diode is greater than the voltage regulator value of the first voltage regulator diode; and when the first switching transistor is turned off, the voltage value of the power supply voltage is the voltage regulator value of the second voltage regulator diode.

3. The power converter according to claim 2, wherein the power supply voltage output end comprises a positive voltage output end, the drive power supply is configured to provide a positive power supply voltage between the positive voltage output end and the reference voltage output end to the control circuit, and the control circuit is configured to generate the turn-on voltage of the drive signal based on the positive power supply voltage; and
the first switching transistor and the first voltage regulator diode are connected in series between the positive voltage output end and the reference voltage output end, and the second voltage regulator diode and the voltage divider capacitor are connected in parallel between the positive voltage output end and the reference voltage output end.

4. The power converter according to claim 3, wherein the power supply voltage output end further comprises a negative voltage output end, the drive power supply is configured to provide a negative power supply voltage between the negative voltage output end and the reference voltage output end to the control circuit, and the control circuit is configured to generate the turn-off voltage of the drive signal based on the negative power supply voltage; and
the drive power supply further comprises a voltage divider resistor and a voltage divider capacitor that are connected in parallel between the negative voltage output end and the reference voltage output end.

5. The power converter according to claim 2, wherein the power supply voltage output end comprises a negative voltage output end, the drive power supply is configured to provide a negative power supply voltage between the negative voltage output end and the reference voltage output end to the control circuit, and the control circuit is configured to generate the turn-off voltage of the drive signal based on the negative power supply voltage; and
the first switching transistor and the first voltage regulator diode are connected in series between the negative voltage output end and the reference voltage output end, and the second voltage regulator diode and the voltage divider capacitor are connected in parallel between the negative voltage output end and the reference voltage output end.

6. The power converter according to claim 5, wherein the power supply voltage output end further comprises a positive voltage output end, the drive power supply is configured to provide a positive power supply voltage between the positive voltage output end and the reference voltage output end to the control circuit, and the control circuit is configured to generate the turn-on voltage of the drive signal based on the positive power supply voltage; and
the drive power supply further comprises a voltage divider resistor and a voltage divider capacitor that are connected in parallel between the positive voltage output end and the reference voltage output end.

7. The power converter according to claim 1, wherein the power supply voltage output end comprises a positive voltage output end and a negative voltage output end, the drive power supply is configured to: provide a positive power supply voltage between the positive voltage output end and the reference voltage output end to the control circuit, and provide a negative power supply voltage between the negative voltage output end and the reference voltage output end to the control circuit, and the control circuit is configured to: generate the turn-on voltage of the drive signal based on the positive power supply voltage and generate the turn-off voltage of the drive signal based on the negative power supply voltage; and
the voltage regulator circuit comprises two groups comprising first switching transistors and first voltage regulator diodes, wherein one group comprising a first switching transistor and a first voltage regulator diode is connected in series between the positive voltage output end and the reference voltage output end, and the other group comprising a first switching transistor and a first voltage regulator diode is connected in series between the negative voltage output end and the reference voltage output end.

8. The power converter according to claim 7, wherein the drive power supply further comprises two groups comprising voltage divider resistors and voltage divider capacitors, wherein one group comprising a voltage divider resistor and a voltage divider capacitor is connected in parallel between the positive voltage output end and the reference voltage output end, and the other group comprising a voltage divider resistor and a voltage divider capacitor is connected in parallel between the negative voltage output end and the reference voltage output end.

9. The power converter according to any one of claims 1 to 8, wherein the voltage regulator circuit further comprises a current-limiting resistor, and the current-limiting resistor is connected in series between the first switching transistor and the first voltage regulator diode.

10. The power converter according to any one of claims 1 to 9, wherein the voltage regulator circuit further comprises a filter device, the filter device is connected to a control end of the first switching transistor, and the filter device comprises at least one of a filter capacitor, a filter resistor, and a filter diode.
